# EUROPEAN PATENT APPLICATION

(11) **EP 2 421 281 A2**
(43) Date of publication of application: **22.02.2012**
(21) Application number: 10179514.4
(22) Date of filing: 24.09.2010
(51) Int. Cl.: H04R 19/04

(54) **Circuit and method for monitoring a capacitive signal source**

(30) Priority: 17.08.2010 EP 10173113
(71) Applicant: NXP B.V., 5656 AE Eindhoven (NL)
(72) Inventor: Van Den Boom, Jeroen, Redhil, Surrey RH1 1D (GB); van Dommelen, Maarten Wilhelmus Henricus, Redhill, Surrey RH1 1DL (GB); Schuurmans, Han Martijn, Redhill, Surrey RH1 1DL (GB)
(74) Representative: Williamson, Paul Lewis

(57) **Abstract**

A circuit for monitoring capacitive signal sources, and particularly detecting changes in capacitance of a variable capacitor, comprises the capacitive signal source (40) and a differential analogue to digital converter (42). A voltage source (44) provides a DC voltage (Vcm) to a first input terminal of the differential analogue to digital converter, and the capacitive signal source(40) is connected to the other terminal of the differential analogue to digital converter (42). A feedback path (46) low pass filters the output of the differential analogue to digital converter (42) to derive a DC offset value (Vcmfb) and couples the DC offset value to the other terminal of the differential analogue to digital converter (42).

## Description

This invention relates to the monitoring of a capacitive signal source, and particularly a variable capacitor, such as a capacitive sensor. Particularly, but not exclusively, the invention relates to capacitive MEMS sensor devices, such as MEMS microphones.

Micro-Electro-Mechanical Systems (MEMS) are becoming standard components in consumer products. For example, integrated MEMS resonators are used in accurate frequency references and filters, MEMS accelerometers are widely used as motion detectors in game consoles and in car and cell phone navigation systems. MEMS microphones are replacing the conventional electret condenser microphone (ECM) in cell phones.

This invention is directed mainly to a problem specific to the interconnection of a capacitor whose capacitance is to be measured (such as a capacitive sensor such e.g. a MEMS microphone) and its signal processor ASIC: how to provide an accurate and stable DC voltage to the interface between the capacitor and its signal processor. The invention applies though to the entire class of capacitive and capacitive-coupled signal sources including the above-mentioned MEMS devices.

A MEMS microphone is a capacitor consisting of a rigid back-plate and a flexible membrane. The nominal capacitance is Cₙₒₘ. An acoustic (air) pressure change Δp changes the distance between the plates by Δd, which results in a change ΔC of the capacitance. In the case of a constant charge on the capacitor, the air pressure change Δp causes a proportional voltage change ΔV across the capacitor terminals.

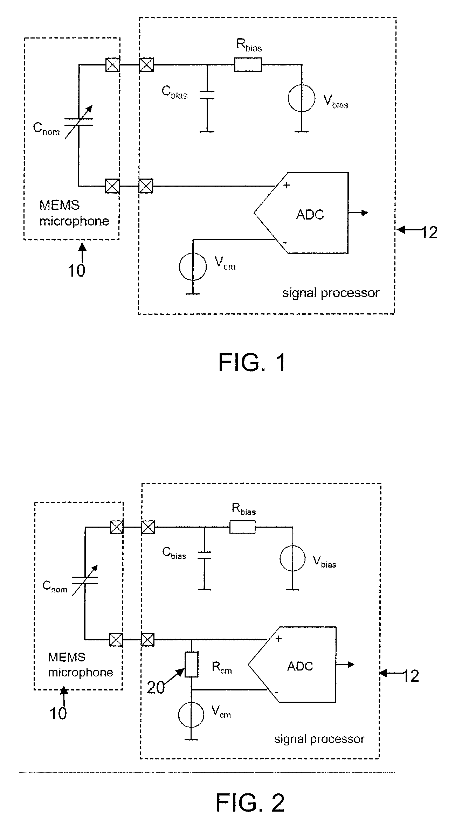

Fig. 1 shows the interconnection between a MEMS microphone and the signal processor chip. The left rectangle 10 is the MEMS chip. Two bond wires connect the sensor with the signal processor chip 12 in the right rectangle.

The processor chip includes a biasing arrangement and an analogue to digital converter, in the form of a 1 bit differential sigma delta converter. The signal processor fulfills at least three basic functions: DC biasing, signal amplification and analog-to-digital conversion. The signal pre-amplifier is assumed to be integrated with the ADC.

The DC biasing circuit consists of a voltage source V_{bias}, a resistor R_{bias} and a capacitor C_{bias}. The -3dB corner frequency of the RC low-pass filter, f_{c}=1/(2π.R_{bias}.C_{bias}), is chosen well below the lowest audio frequency of 20 Hz. For audio frequencies, this results in a constant charge on the microphone capacitor. The capacitance of C_{bias} is at least an order larger than Cₙₒₘ. Thus it provides a virtual ground for the microphone's signal voltage. The signal voltage is either supplied to a pre-amplifier or directly to the analog-to-digital converter (ADC). The inverting input is connected to a DC common-mode voltage V_{cm}. The microphone signal is supplied to the non-inverting input.

A problem is that the DC voltage at the non-inverting input (+) is undefined since the sensor is a capacitor. More specifically, the input stage requires equal DC voltages at both inputs. The simplest way to realize this is by connecting a resistor 20 (value R_{cm}) between the inverting and non-inverting inputs as depicted in Fig. 2. The combination of the sensor's capacitance Cₙₒₘ and the resistor R_{cm} forms an RC high-pass filter for the microphone's audio signal. The -3dB corner frequency f_{c}=1/(2π.R_{cm}.Cₙₒₘ) must be below 20 Hz to prevent low-frequency signal loss. A practical value of Cₙₒₘ is 3 pF. This results in a minimum value of 3 GΩ for R_{cm}. In other words, the DC bias source must be extremely high-ohmic. In this design, the resistor defines the DC voltage at the non-inverting input.

In CMOS technologies it is not possible to implement a resistor in the GΩ2-range. Practically, resistor values are limited to ~10 MΩ. The R_{ds} of a long-channel MOS transistor has a comparable upper limit. The only component by which a differential (small-signal) resistance in the GΩ-range can be realized is a bipolar diode. The relationship between differential resistance R_{diff} and the forward diode current I_{d} is: R_{diff} = kT/q.I_{d} in which kT/q=25 mV. A minimum resistance of 3 GΩ implies a maximum forward current of 8 pA, which is extremely small.

In reality two main sources of leakage spoil the ideal situation of Fig. 2. First, the microphone is exposed to the moist breath of the person speaking. The air near the sensor becomes a conductor with an estimated resistance of 10 GΩ or higher. In case of a V_{bias}=10 V it results in a leakage current Iₗₑₐₖ₁ up to 1 pA. Second, there are leakage currents through electrostatic discharge protection circuits.

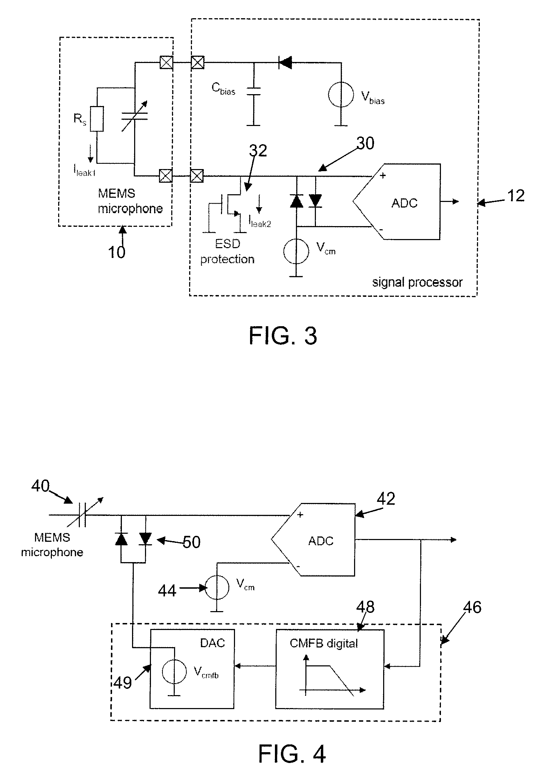

Fig. 3 shows the use of two anti-parallel diodes 30 to provide a very high resistance in series with the reference voltage.

As depicted in Fig. 3, a shunt resistor Rₛ is used to represent the leakage current path across the microphone. This pulls the DC voltage at the non-inverting input high.

The non-inverting input must be protected against electrostatic discharges (ESD). The grounded-gate NMOST protection 32 as depicted in Fig. 3 causes a leakage current Iₗₑₐₖ₂ to ground. This pulls the DC voltage at the non-inverting input down. The ESD leakage current can be limited to 1 .. 10 pA. Its actual value is strongly temperature-dependent.

Concluding, the pull-up and pull-down currents are uncorrelated and uncontrollable. Therefore two anti-parallel diodes must be applied. One of these must provide the net current up to 10 pA. Depending on the diode area and temperature, the voltage V_{forward} across the forward diode can be as high as 500 mV. A practical value of the sensor's signal voltage is 100 mVᵣₘₛ at the maximum audio input level of 120 dB SPL. The DC offset exceeds the peak signal voltage by a factor of 3.5, and as a consequence the dynamic range has to be increased proportionally, with an unacceptable impact on current consumption and die area.

Thus, it can be seen that leakage currents in the microphone and in the ESD protection circuit 32 cause a voltage across the anti-parallel diodes resulting in a large offset between the ADC inputs. There remains a need for a circuit which is able to maintain equal DC voltages at the ADC terminals and which can be implemented in practice, preferably in CMOS technology.

According to the invention, there is provided a circuit for monitoring a capacitive signal source, comprising:
a capacitive signal source;
a differential analogue to digital converter having first and second input terminals;
a voltage source for providing a DC voltage to the first input terminal of the differential analogue to digital converter, wherein the capacitive signal source is connected to the second terminal of the differential analogue to digital converter;
a feedback path for low pass filtering the output of the differential analogue to digital converter to derive a DC offset value and for coupling the DC offset value to the second terminal of the differential analogue to digital converter.

This arrangement replaces the fixed voltage applied to one of the ADC inputs with a common mode voltage derived from a feedback loop.

In the area of particular interest, notably the MEMS microphone in the above discussion, the capacitive signal source comprises a variable capacitor, and the circuit detects changes in the capacitance of the variable capacitor. As mentioned previously, though, the invention can be applied to circuits for monitoring capacitive signal source more generally, including capacitive coupled signal sources.

The differential analogue to digital converter can comprise a sigma delta converter, for example a one bit sigma delta converter.

The feedback path preferably comprises a digital low pass filter and a digital to analogue converter. The digital low pass filter is able to remove components at frequencies at which the capacitance is expected to vary (for example frequencies to be sensed by the variable capacitor sensor).

The digital to analogue converter can comprise a charge pump circuit for charging or discharging a capacitor. This provides a low noise power efficient converter.

The DC offset value can be coupled to the second terminal of the differential analogue to digital converter by a pair of parallel back-to-back diodes.

However, a different digital to analogue converter design avoids the need for the diode arrangement. Thus, the digital to analogue converter can comprise:
a first charge pump circuit for charging or discharging a first capacitor, with the voltage on the first capacitor controlling the switching of a first current source;
a second charge pump circuit for charging or discharging a second capacitor, with the voltage on the second capacitor controlling the switching of a second current source,
wherein the first and second current sources are operated in complementary manner and are both directly connected to the second terminal of the differential analogue to digital converter.

The first and second current sources can each comprise a transistor connected between a respective power line and the second terminal of the differential analogue to digital converter.

The variable capacitor may be a capacitive sensor, for example a capacitive MEMS sensor such as a MEMS microphone or MEMS accelerometer

The invention also provides a method of monitoring a capacitive signal source, comprising:
providing a DC voltage to a first input terminal of a differential analogue to digital converter, wherein the capacitive signal source is connected to a second terminal of the differential analogue to digital converter;
low pass filtering the output of the differential analogue to digital converter to derive a DC offset value and coupling the DC offset value to the second terminal of the differential analogue to digital converter.

An example of the invention will now be described in detail with reference to the accompanying drawings, in which:
Figure 1 shows a known MEMS microphone and associated circuitry;
Figure 2 shows a first known modification to the circuitry of Figure 1;
Figure 3 shows a second possible modification to the circuitry of Figure 1 contemplated by the applicant;
Figure 4 shows a MEMS microphone and associated circuitry in accordance with the invention;
Figure 5 is used to explain the digital control functions in the circuit of Figure 4;
Figure 6 shows in schematic form a first possible design of digital to analogue converter used in the circuit of Figure 4;
Figure 7 shows the circuit of Figure 6 in more detail;
Figure 8 shows waveforms for the operation of the circuit of Figure 7; and
Figure 9 shows in schematic form a second possible design of digital to analogue converter used in the circuit of Figure 4.

The invention provides a circuit for monitoring a capacitive signal source, in which a voltage source provides a DC voltage to a first input terminal of an analogue to digital converter. A feedback path low pass filters the output of the differential analogue to digital converter to derive a DC offset value and coupes the DC offset value to a second terminal of the differential analogue to digital converter. This arrangement replaces the fixed voltage applied to one of the ADC inputs with a common mode voltage derived from a feedback loop. In the particular example embodiments described hereafter, the circuit detects changes in the capacitance of a variable capacitor, comprising a MEMS microphone, but can similarly be applied to capacitive sensors more generally, and other capacitive signal sources, including capacitively coupled signal sources.

The invention is based on the recognition that the offset problem can be solved by replacing the fixed voltage V_{cm} in Fig. 3 by a controlled common-mode voltage V_{cmfb} as depicted in Fig. 4, which shows a MEMS microphone and associated circuitry in accordance with the invention.

The circuit comprises the microphone 40 (or generally a variable capacitance), and a differential analogue to digital converter 42.

A voltage source 44 provides a DC voltage Vcm to a first, inverting, input terminal of the differential analogue to digital converter 42, and the microphone is connected to the other, non-inverting, terminal of the differential analogue to digital converter 42.

A feedback path 46 is for low pass filtering the output of the differential analogue to digital converter 42 to derive a DC offset value and for coupling the DC offset value to the non-inverting terminal of the differential analogue to digital converter 42. The feedback path comprises a filter 48 and a digital to analogue converter DAC 49.

Of course, the fixed voltage Vcm could be associated with the ADC input to which the microphone is connected and the variable feedback voltage could be associated with the other ADC input. Also, the sensor input could be to the inverting input, so long as subsequent signal processing takes account of this.

The audio signal source from the microphone 40 is here connected to the non-inverting input of the analogue to digital converter 42 because, in general, inversions in audio channels are to be avoided.

Figure 4 also shows a pair of parallel back-to-back diodes 50 used to couple the DC offset value determined in the feedback loop to the non-inverting input terminal. It will be explained below that these diodes are optional, in that some designs of DAC 49 can avoid the need for these components.

The control circuit measures the offset between the inverting and non-inverting inputs by observing the ADC output signal, and adjusts the common-mode feedback voltage accordingly. In order to avoid additional noise due to audio signal feedback it is necessary to distinguish between the DC offset voltage and the superimposed audio signal. This requires a filter with a corner frequency between 0 and 20 Hz.

It may be difficult to realise such a filter with sufficient accuracy in the analog domain without using external components because the capacitor value is limited to the pF-range and, consequently, the resistor must be in the GΩ-range. If the RC-time constant becomes too short, the control loop will interfere with low-frequency audio signals. If it becomes too long, the response becomes too slow.

Thus, the ADC is used as a feedback loop component. The bit-stream signal at the ADC output is applied to a digital low-pass filter 48. A digital-to-analog converter (DAC) 49 converts the digitally filtered control signal into the analog control voltage V_{cmfb}.

In the figures, CMFB is used as an abbreviation for the Common-Mode Voltage Feedback loop.

Two main origins of undesirable offset have been mentioned above: leakage currents in the microphone and in the ESD protection. Both currents are quasi-static, i.e. they vary much slower than the lowest-frequency audio signal (20 Hz).

A third offset component is caused by the mismatch between the inverting and non-inverting ADC inputs. This is a static offset caused by component spread.

A fourth offset component is generated deliberately in case the ADC is a Delta-Sigma Modulator. For (almost) zero input signals the feedback loop inside this type of converter generates idle tones for which the frequency can be in the audio band. By adding a DC offset these tones can be shifted outside the audio band. This technique is known as (DC-) dithering. The control loop must eliminate the first, second and third offset component, while not interfering with the fourth component.

In order to deal with the quasi-static leakages, an integrator is required in the digital filter. The DAC capacitor acts as a second integrator so the loop contains two poles. A proportional path in the digital filter must provide a zero to ensure loop stability.

The DAC 49 converts the digital control signal into an analog control voltage. Since the noise at the DAC output is directly added to the microphone signal, its dynamic range must be at least as high as for the signal path. This requirement leads to two preferred implementations described below.

As depicted in Fig. 4, the common-mode feedback loop consists of three building blocks: the ADC, the digital filter part and the DAC (which can be considered to include the anti-parallel diode pair 50). These are discussed in more detail in turn.

### The ADC

The ADC in the MEMS microphone ASIC is a one-bit sigma-delta converter. The output signal is a pulse-density modulated (PDM) bit-stream. The ratio between the number of '1's and '0's is a measure for the DC component.

### The digital control part

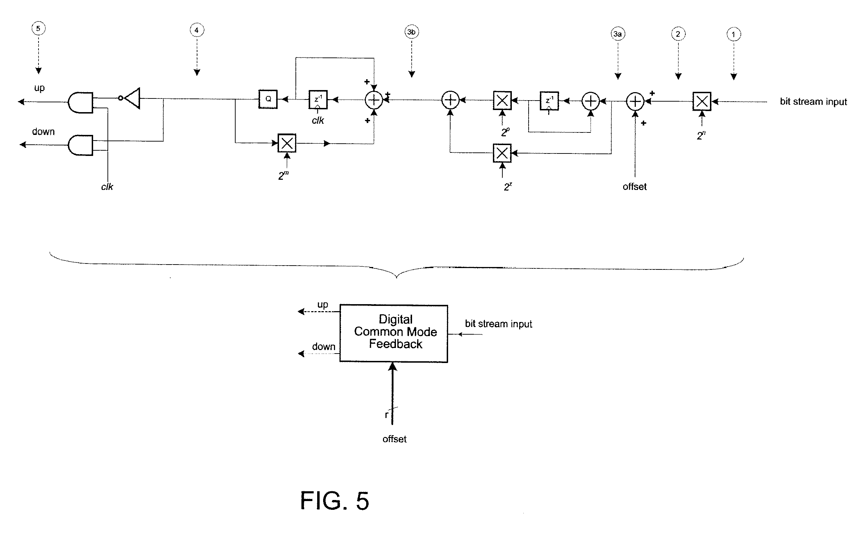

The CMFB digital part extracts the DC component from the bit-stream. Besides the bit-stream input, the intentional dithering offset is also added. In one example below, the output signals to the DAC are 'up' and 'down' control pulses. The functional block diagram as depicted in Fig. 5 performs the following operations on the bit-stream:
(1) - (2): expansion of single-bit stream into multi-bit signal, multiplication by a scaling factor 2ⁿ
(2) - (3a): adding the intentional dithering offset
(3a) - (3b): integrator and proportional path in parallel. The latter provides a zero to maintain stability of the CMFB loop.
(3b) - (4): first-order delta-sigma modulator
(4) - (5): conversion of the multi-bit signal in two single-bit streams of 'up' and 'down' pulses

The CMFB digital part can also cooperate with multi-bit delta-sigma AD converters, as well as other converter types. This requires limited modifications.

### The DAC

The common-mode feedback voltage is supplied directly to the ADC input stage. Therefore the noise at the DAC output is added to the microphone signal. The following figures apply to the system:
- maximum microphone output signal is 100 mVᵣₘₛ
- required dynamic range is 90 dB
- maximum current consumption is 400 pA

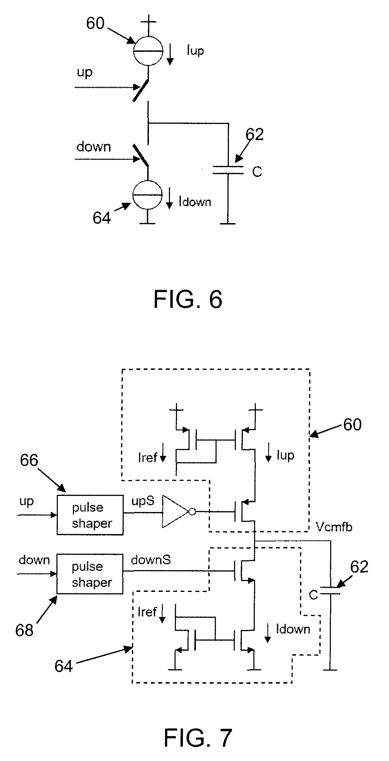

This corresponds to an equivalent input noise level of 3.1 µVᵣₘₛ over the audio bandwidth of 20 kHz. An analog output buffer having an equal output noise consumes approximately 100 pA. This does not fit in the total budget of 400 pA. A more power-efficient low-noise DAC can be realized with a charge pump and a capacitor as depicted in Fig. 6 in schematic form.

Figure 6 shows a current source 60 for charging a capacitor 62 and a current source 64 for discharging the capacitor. Switches control the charge flow.

The digital-to-analog converter integrates charge packets on the capacitor. Digital control signals 'up' and 'down' activate the charge pump. The analog output signal is the voltage across the capacitor.

An 'up' pulse activates the upper current source 60 resulting in a positive voltage step across the capacitor. A 'down' pulse results in a voltage step of the opposite sign. The voltage steps across the capacitor must be smaller than the equivalent input noise.

The circuit diagram is depicted in Fig. 7. The current sources 60.62 are implemented as current mirror circuits and the control signals are supplied through pulse shapers 66, 68.

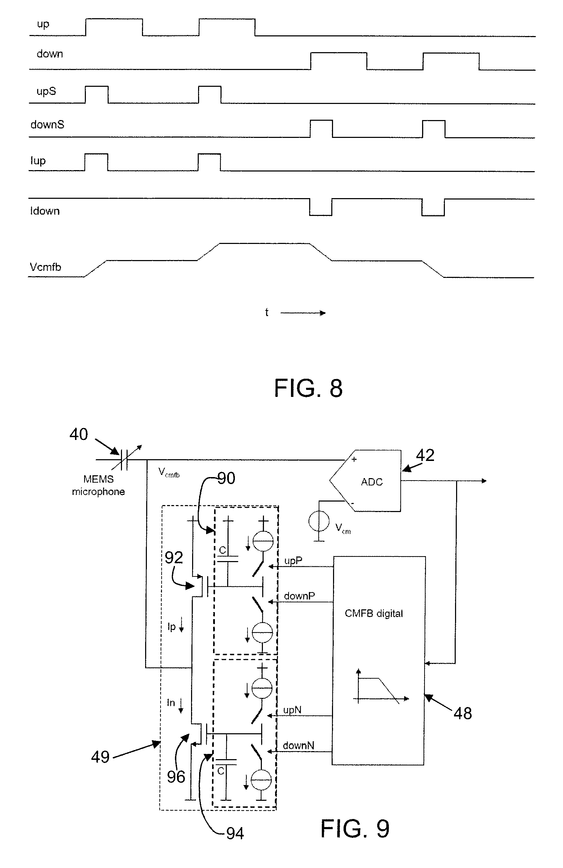

Fig. 8 shows the corresponding signals. The 'up' (and 'down') pulse length is equal to the system clock period. This is too long to realize the required voltage step size. The analog pulse shapers shorten the pulse 'up' and 'down' to 'upS' and 'downS'. The shortened pulse controls a switch which activates the flow of current Iᵤₚ (I_{down}) to the capacitor. This results in a voltage Step ΔV_{cmfb} = Iᵤₚ.t_{upS}/C (ΔV_{cmfb} = I_{down}.t_{downS}/C).

The output voltage (the bottom plot Vcmfb) is the common mode voltage coupled to the ADC input.

In order to keep the steps ΔV_{cmfb} below the noise, they must be smaller than 3.1 µV. The capacitor, current and pulse times are subject to practical limitations. The capacitance is limited by its area. In a typical CMOS process, a 50 pF capacitor requires 75 x 75 µm2 which is acceptable. A practical minimum pulse time is 1 ns. Although an analog pulse generator can produce shorter pulses, the accuracy of the switched charge packet drops rapidly due to parasitic effects. The current has a practical lower limit of 50 nA. For smaller values the mismatch between I_{ref} and Iᵤₚ (I_{down}) in the current mirror becomes too large. This combination yields a step size ΔV_{cmfb} = 50 nA.1ns/50pF=1 µV, which fulfills the noise requirement.

The charge pump DAC of Figures 6 and 7 has a low-impedance output. The required very high impedance at the ADC input node is obtained by placing the back to back diodes 50 between the DAC output and the ADC input.

In an alternative solution the high impedance can be achieved without any series diode. The principle is depicted in Fig. 9.

The digital to analogue converter 49 comprises:
a first charge pump circuit 90 for charging or discharging a first capacitor, with the voltage on the first capacitor controlling the switching of a first current source transistor 92 for supplying current to the non-inverting ADC input; and
a second charge pump circuit 94 for charging or discharging a second capacitor, with the voltage on the second capacitor controlling the switching of a second current source transistor 96 for draining current from the non-inverting ADC input.

The first and second current sources are operated in complementary manner and are both directly connected to the non-inverting terminal of the differential analogue to digital converter 42.

In this way, a complementary pair of controlled current sources is connected directly to the ADC input. Only one of them is active at a time. Each of them is controlled by its own charge pump.

The main disadvantage of a diode is related to electro-magnetic interference (EMI). In a cell phone, the bond wires between the MEMS microphone and the ASIC can pick up the RF transmitter signal, and the diodes demodulate the signal into the audio band where it appears as noise. Therefore it is desirable to avoid diodes connected to the signal path.

Each of the two current sources is controlled by its own charge-pump DAC. This 'dual charge-pump DAC' has a disadvantage over the single charge-pump DAC of Fig. 7 in terms of complexity. Two pairs of up/down control signals are required. They must cooperate accurately so only one of the complementary current sources is active at a time. A cross-current would lower the impedance level at the ADC input, thus causing a high-pass filtering of the microphone signal. However, the additional complexity does enable the removal of the diodes from the circuit.

The CMFB control loop is of particular interest for MEMS microphones. The circuit can provide a current consumption less than 3 pA, and the complete circuit fits in a chip area of 0.04 mm2.

The applications are not limited to MEMS microphones. The CMFB can be applied to other capacitive MEMS sensors, e.g. accelerometers. More generally, it can be applied to all capacitive and capacitive-coupled signal sources.

The circuit of the invention provides an accurate and stable common-mode voltage which is insensitive to leakage currents. This allows an optimum match between the MEMS microphone and the pre-amplifier or ADC.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A circuit for monitoring a capacitive signal source, comprising:
a capacitive signal source(40);
a differential analogue to digital converter (42) having first and second input terminals;
a voltage source (44) for providing a DC voltage (Vcm) to the first input terminal of the differential analogue to digital converter, wherein the capacitive signal source (40) is connected to the second terminal of the differential analogue to digital converter (42);
a feedback path (46) for low pass filtering the output of the differential analogue to digital converter (42) to derive a DC offset value (Vcmfb) and for coupling the DC offset value to the second terminal of the differential analogue to digital converter (42).

2. A circuit as claimed in claim 1, wherein the differential analogue to digital converter (42) comprises a sigma delta converter.

3. A circuit as claimed in any preceding claim, wherein the differential analogue to digital converter (42) comprises a one bit sigma delta converter.

4. A circuit as claimed in any preceding claim, wherein the feedback path (46) comprises a digital low pass filter (48) and a digital to analogue converter (49).

5. A circuit as claimed in claim 4, wherein the digital low pass filter (48) comprises an adder for adding DC dither to remove idle tones.

6. A circuit as claimed in claim 4 or 5, wherein the digital to analogue converter (49) comprises a charge pump circuit (60,64) for charging or discharging a capacitor (62).

7. A circuit as claimed in any preceding claim, wherein the DC offset value (Vcmfb) is coupled to the second terminal of the differential analogue to digital converter (42) by a pair of parallel back-to-back diodes (50).

8. A circuit as claimed in any one of claims 1 to 4, wherein the digital to analogue converter (49) comprises:
a first charge pump circuit (90) for charging or discharging a first capacitor, with the voltage on the first capacitor controlling the switching of a first current source (92);
a second charge pump circuit (94) for charging or discharging a second capacitor, with the voltage on the second capacitor controlling the switching of a second current source (96),
wherein the first and second current sources (92,96) are operated in complementary manner and are both directly connected to the second terminal of the differential analogue to digital converter (42).

9. A circuit as claimed in claim 8, wherein the first and second current sources (92,96) each comprise a transistor connected between a respective power line and the second terminal of the differential analogue to digital converter (42).

10. A circuit as claimed in any preceding claim, wherein the capacitive signal source comprises a variable capacitor and the circuit detects changes in the capacitance of the variable capacitor.

11. A circuit as claimed in claim 10, wherein the variable capacitor (40) comprises a capacitive sensor.

12. A circuit as claimed in claim 11, wherein the variable capacitor (40) comprises a capacitive MEMS sensor.

13. A circuit as claimed in claim 10, wherein the variable capacitor (40) comprises a MEMS microphone.

14. A method of monitoring a capacitive signal source, comprising:
providing a DC voltage (Vcm) to a first input terminal of a differential analogue to digital converter (42), wherein the capacitive signal source (40) is connected to a second terminal of the differential analogue to digital converter (42);
low pass filtering the output of the differential analogue to digital converter (42) to derive a DC offset value (Vcmfb) and coupling the DC offset value to the second terminal of the differential analogue to digital converter (42).

15. A method as claimed in claim 14, comprising detecting the signal from a MEMS microphone (40).
